# EUROPÄISCHE PATENTSCHRIFT

(11) **EP 0 446 596 B1**
(45) Veröffentlichungstag und Bekanntmachung des Hinweises auf die Patenterteilung: **09.11.1994**
(21) Anmeldenummer: 91101392.8
(22) Anmeldetag: 02.02.1991
(51) Int. Cl.: C23C 16/50, C23C 16/44, C03C 17/09, C03C 17/245, G02B 5/08

(54) **PCVD-Verfahren zur Herstellung eines auf der Innen- und/oder Aussenfläche mit einem dielektrischen und/oder metallischen Schichtsystem versehenen annähernd kalottenförmigen Substrats**
PCVD process for the production of approximately dome-shaped substrates provided on the inside and/or outside with dielectric and/or metallic coating systems
Procédé PCVD pour la production de substrats sous la forme de calotte pourvus à l'intérieur et/ou à l'extérieur de revêtements diélectriques et/ou métalliques

(30) Priorität: 16.03.1990 DE 4008405
(43) Veröffentlichungstag der Anmeldung: 18.09.1991
(73) Patentinhaber: Schott Glaswerke, 55122 Mainz (DE); Carl-Zeiss-Stiftung trading as SCHOTT GLASWERKE, 55122 Mainz (DE)
(72) Erfinder: Etzkorn, Heinz Werner, Dr., W-6392 Neu Anspach (DE); Krümmel, Harald, W-6500 Mainz (DE); Paquet, Volker, W-6500 Mainz 21 (DE); Weidmann, Günter, W-6509 Armsheim (DE)

(56) Entgegenhaltungen:
- EP-A- 0 017 296
- US-A- 3 731 650
- US-A- 3 926 508
- PATENT ABSTRACTS OF JAPAN, vol. 13, no. 145 (C-583)(3493), 10. April 1989; & JP-A-63 307 192

## Beschreibung

Die Erfindung betrifft ein Plasma-CVD-Verfahren zur Herstellung eines auf der Innen- und/oder Außenfläche mit einem dielektrischen und/oder metallischen Schichtsystem versehenen im wesentlichen kalottenförmigen Substrats, insbesondere eines Reflektors mit innenseitiger dielektrischer Kaltlichtspiegelbeschichtung, sowie eine Vorrichtung zur Durchführung des Verfahrens.

Reflektoren bestehen in der Regel aus gewölbten, meist kalottenähnlich geformten Glassubstraten mit einer innenseitigen Reflexionsbeschichtung. Die Reflexionsbeschichtung kann aus einer metallischen Schicht oder aber, wenn ein spezieller spektraler Verlauf des Reflexionsgrades gewünscht ist, aus einem dielektrischen Schichtsystem bestehen. So kann man z.B. sog. Kaltlichtspiegel, wie z.B. Zahnarztspiegel, herstellen, welche nur im sichtbaren Spektralbereich einen hohen Reflexionsgrad aufweisen, für Wärmestrahlung hingegen durchlässig sind.

Dielektrische Schichtsysteme mit einem selektiven spektralen Reflexionsvermögen bestehen i.a. aus alternierend übereinander angeordneten Schichten mit hohem und niedrigem Brechnungsindex. Wie solche Schichtsysteme im einzelnen aufzubauen sind, d.h. wieviele Schichtpaare übereinander anzuordnen sind und wie die Schichtdicken zur Erzielung eines gewünschten optischen Effekts zu bemessen sind, ist dem Fachmann bekannt und z.B. in H.A. Macleod, Thin Film Optical Filters, A. Hilger Ltd., London,beschrieben.

Üblicherweise werden die dielektrischen Schichtsysteme mittels Hochvakuumverfahren, wie z.B. Hochvakuumbedampfung, Kathodenzerstäubung oder Elektronenstrahlzerstäubung auf die Substrate aufgebracht. Um ohne komplizierte Bewegung eines stark gewölbten Substrats eine gleichmäßige Beschichtung der Substratinnenfläche zu erhalten, wird in der Regel ein "Gasstreuverfahren" (K. Steinfelder u.a., Vakuumtechnik 28 (1979), S. 48) eingesetzt. Dabei wird die Bedampfung unter erhöhtem Druck (etwa 10⁻³mbar) eines Zusatzgases durchgeführt, das die Aufgabe hat, die geradlinige Bewegung der Dampfpartikel von der Aufdampfquelle zum Substrat hin durch Vielfachstöße mit dem Zusatzgas zu unterbrechen, so daß keine Vorzugsrichtung in der Bewegung der Dampfpartikel mehr besteht. Nach diesem Verfahren können sog. "weiche" Schichtsysteme aus ZnS/MgF₂-Schichtpaaren hergestellt werden, die aber griffempfindlich sind, und sog. "halbharte" Schichtsysteme aus ZnS/SiO₂- und ZnS/Al₂O₃-Schichtpaaren, die zwar griffest, aber mechanisch nicht belastbar sind.

Neben dem Gasstreuverfahren ist noch ein weiteres Hochvakuumbedampfungsverfahren bekannt (H.K. Pulker, Coatings on Glass, Elsevier, Amsterdam 1984), bei welchem die Substrate zur Erzielung einer gleichmäßigen Beschichtung während des Bedampfens auf Planetenhalterungen eine zweifache Rotationsbewegung ausführen. Mit den oben beschriebenen Schichtsystemen versehene Reflektoren (Durchmesser am Kalorienfuß ca. 5 cm) haben jedoch den Nachteil, daß sie bei hoher Luftfeuchtigkeit früh ausfallen und thermisch nicht stabil genug sind, um der in der Regel hohen Wärmeentwicklung der üblicherweise eingesetzten Halogenglühlampen auch bei elektrischen Leistungen von über 50 W noch standzuhalten.

Mit Elektronenstrahlverdampfung im Hochvakuum lassen sich SiO₂/TiO₂-Schichtsysteme herstellen, die bezüglich ihrer mechanischen, chemischen und thermischen Belastbarkeit hohen Anforderungen genügen und daher üblicherweise als sog. "harte" Schichtsysteme bezeichnet werden. Aufgrund der schwierigeren Herstellung (z.B. komplizierte Substratbewegung, Substratheizung) sind diese Schichtsysteme auf stark gewölbten Substraten jedoch um ein mehrfaches teurer als die weichen Schichten.

Der Erfindung liegt die Aufgabe zugrunde, ein einfach durchführbares und kostengünstiges Verfahren bereitzustellen, welches geeignet ist, stark gewölbte, großflächige Substrate, wie z.B. Kalotten, auf der Innen-und/oder Außenfläche mit einem dielektrischen und/oder metallischen Schichtsystem von höchster optischer Qualität und mechanischer, thermischer sowie chemischer Stabilität zu versehen. Insbesondere soll das Verfahren zur Herstellung von Reflektoren mit innenseitiger dielektrischer Kaltlichtspiegelbeschichtung geeignet sein.

Eine weitere Aufgabe der Erfindung besteht darin, eine für die Durchführung des Verfahrens geeignete Vorrichtung zu finden.

In bezug auf das Verfahren wird die Aufgabe durch das in den Patentansprüchen 1 oder 5 beschriebene Verfahren gelöst. In den Patentansprüchen 6, 7 und 11 werden bevorzugte Vorrichtungen zur Durchführung des erfindungsgemäßen Verfahrens beschrieben.

Die üblicherweise zur Innenbeschichtung rohrförmiger Glasrohlinge zur Herstellung von Lichtleitfasern eingesetzten Plasma-CVD-Verfahren sind an sich bekannt. Eine grundlegende Beschreibung ist z.B. in Journal of Optical Communications, vol.8 (1987), S. 122, zu finden.

Von diesen Verfahren ist insbesondere das Plasmaimpuls-CVD-Verfahren (s. hierzu z.B. Journal of Optical Communications, vol.8 (1987), S. 130) zur Herstellung dielektrischer Schichtsysteme mit definierten optischen Eigenschaften geeignet. Mittels des Plasmaimpuls-CVD-Verfahrens lassen sich sehr dünne gleichmäßige Schichten bis hin zu monomolekularen Schichten auf Substraten erzeugen.

Der Begriff Plasma-CVD-Verfahren schließt im Sinne dieser Erfindung das Plasmaimpuls-CVD-Verfahren mit ein. Das Plasmaimpuls-CVD-Verfahren wird sogar bevorzugt verwendet.

Die mittels Plasma-CVD-Verfahren hergestellten Schichten zeichnen sich nicht nur durch eine sehr hohe optische Qualität aus, sie sind darüber hinaus auch noch chemisch, mechanisch und thermisch außerordentlich stabil. Diese vorteilhaften Eigenschaften, verdanken sie der Tatsache, daß sie hinsichtlich der Stöchiometrie und Morphologie praktisch die Eigenschaften von Massivmaterial aufweisen.

Die Erfindung macht sich die Tatsache zunutze, daß die Plasma-CVD-Verfahren an sich hervorragend zur Beschichtung kompliziert geformter Teile geeignet sind, da sie eine hohe Streuwirkung besitzen. Es ist bei diesen Verfahren nicht nötig, die Substrate zur Erzielung einer gleichmäßigen Beschichtung zu drehen oder in sonst irgendeiner Weise zu bewegen. Trotz dieses Vorteils konnten Plasma-CVD-Verfahren bisher lediglich zur Beschichtung kleinflächiger, stark gewölbter Substrate eingesetzt werden.

In der EP-PS 0 017 296 wird z.B. ein Plasma-CVD-Verfahren zur Herstellung kugelförmiger Mikrolinsen beschrieben, wonach eine Glasplatte zur Aufnahme der Linsen mit ca. 35 µm tiefen Vertiefungen versehen wird. Bei der anschließend erfolgenden Beschichtung wird über der gesamten Glasplatte eine Plasmazone erzeugt, welche sich bis in die Vertiefungen hinein erstreckt. Dies hat zur Folge, daß das Schichtmaterial nicht nur auf der Oberfläche der Glasplatte, sondern auch in die Vertiefungen abgeschieden wird, wobei in an sich bekannter Weise durch Änderung der Reaktionsgaszusammensetzung während der Beschichtung ein gewünschtes Brechzahlprofil in der atigeschiedenen Schicht erzeugt werden kann. Die Beschichtung wird nach der obengenannten Druckschrift erst dann gestoppt, wenn die Vertiefungen vollständig mit Schichtmaterial aufgefüllt sind. In weiteren Verfahrensschritten (Planschleifen der Oberfläche und Verkleben mit einer weiteren beschichteten Platte, so daß jeweils zwei Halbkugeln zu einer Kugel zusammengesetzt werden) werden aus der beschichteten Glasplatte in Glasrahmen eingebettete Kugellinsen hergestellt.

Das oben beschriebene Verfahren läßt sich jedoch nicht auf die Beschichtung stark gewölbter Substrate mit größeren Abmessungen (⌀ ≳ 5 mm am Kalottenfuß), wie z.B. Reflektoren mit kalottenähnlich geformter Reflektorfläche, welche für die gebräuchlichsten Anwendungen in der Regel am Kalottenfuß einen Durchmesser von wenigstens 20 mm besitzen, übertragen, da die Dicke einer zur Beschichtung geeigneten Plasmazone über der zu beschichtenden Fläche üblicherweise auf einige 10 mm beschränkt ist und das Plasma somit nicht, wie zur Erzeugung einer gleichmäßigen Innen- bzw.

Außenbeschichtung erforderlich, den gesamten Körper auf der zu beschichtenden Seite einschließen kann. Bei größeren Dicken des Plasmabereichs steigt die Wahrscheinlichkeit, daß sich nicht nur an der Grenzfläche Substrat/Gasraum, sondern im gesamten Gasraum in einer sog. Homogenreaktion Partikel bilden, welche sich dann als Glasruß auf der Substratoberfläche absetzen und in die abgeschiedenen Schichten miteingebaut werden. Dadurch wird die Schichtqualität so stark verschlechtert, daß die Schichten unbrauchbar werden.

Das erfindungsgemäße Verfahren wird im folgenden am Beispiel der insbesondere für die Anwendung interessanten Innenbeschichtung von Substraten, z.B. zur Herstellung von Reflektoren, beschrieben. Die nachfolgenden Ausführungen sind jedoch ohne wesentliche Einschränkungen auch für die Außenbeschichtung von Substraten nach dem erfindungsgemäßen Verfahren gültig. Insbesondere können die für die Innenbeschichtung beschriebenen Vorrichtungen in einfacher Weise durch die umgekehrte Anordnung der Substrate und eine entsprechende Formgebung der Verdrängungskörper auf die Außenbeschichtung umgerüstet werden. Eine Ausnahme stellt lediglich das in Patentanspruch 5 beschriebene Verfahren dar, das ausschließlich zur Innenbeschichtung geeignet ist.

Nach der Erfindung wird zur Innenbeschichtung eines im wesentlichen kalottenförmigen Substrats, im folgenden auch Kalotte genannt, in dem von dem gewölbten Substrat begrenzten, halbseitig offenen Hohlraum ein sog. Verdrängungskörper beabstandet und verschiebbar zu der zu beschichtenden Fläche angeordnet. Mit Hilfe des Verdrängungskörpers, dessen Gestalt auf der der zu beschichtenden Substratfläche zugewandten Seite im wesentlichen der Gestalt der Substratfläche entspricht, stellt man die Dicke der zu reagierenden Gasschicht über der zu beschichtenden Fläche so ein, daß das Ausmaß der in der Gasschicht während einer Plasmaphase auftretenden Homogenreaktion ("Glasrußbildung") für die gewünschte Schichtqualität unschädlich bleibt.

Für die Herstellung dielektrischer Interferenzschichtsysteme für Reflektoren ist die Schichtqualität in der Regel ausreichend gut, wenn der Abstand 20 mm nicht übersteigt. Ein Abstand von weniger als 2 mm sollte dagegen nicht unterschritten werden, da sonst zu hohe Anforderungen an die Positioniergenauigkeit des Verdrängungskörpers gestellt werden.

Zur Durchführung der Beschichtung werden in an sich bekannter Weise die Reaktionsgase in den Reaktionsraum eingeleitet und das schichtbildende Plasma gezündet.

Als Reaktionsgase werden bei PCVD-Verfahren üblicherweise Metallchloride, metallorganische Verbindungen, Sauerstoff, Stickstoff und Ammoniak eingesetzt. Für die Abscheidung der für Reflektoren mit Kaltlichtverspiegelung geeigneten "harten" SiO₂/TiO₂-Schichtsysteme können neben Sauerstoff z.B. SiCl₄ und TiCl₄ als Reaktionsgase verwendet werden. Die Verwendung von SiCl₄ hat jedoch den Nachteil, daß, um den Einbau von Chlor in die Schichten zu verhindern, hohe Substrattemperaturen erforderlich sind. Für die Beschichtung von Kalotten nach dem erfindungsgemäßen Verfahren wird die Verwendung von Hexamethyldisiloxan anstelle des SiCl₄ bevorzugt, da damit die Notwendigkeit für hohe Substrattemperaturen entfällt und das Verfahren wirtschaftlicher arbeitet.

Für die Anregung des Plasmas kommen alle hierfür bekannten Methoden, wie z.B. Hochfrequenz-, Niederfrequenz-, Mikrowellen-, Gleichspannungs-, oder gepulste Gleichspannungsanregung in Frage. Die Hoch- und Niederfrequenzanregung kann sowohl kapazitiv als auch induktiv erfolgen.

Bei dem erfindungsgemäßen Verfahren wird die Mikrowellenanregung bevorzugt. Die Mikrowellenanregung hat den Vorteil, daß die Gefahr der Strahlenschädigung der abgeschiedenen Schichten gering ist, daß die für einen Prozeß notwendige Plasmaleistung mit zunehmender Frequenz sinkt, daß der Einkoppelwirkungsgrad hoch ist und Mikrowellenplasmen über weite Druckbereiche (etwa 10⁻³ bis 50 mbar) betrieben werden können.

Neben diesen mehr allgemeinen, für jedes PCVD-Verfahren zutreffenden Vorteilen; ist die Verwendung eines Mikrowellenplasmas für das erfindungsgemäße Verfahren noch dadurch besonders günstig, daß durch die Beschränkung des Plasmabereichs auf möglichst kleine Volumina weniger leistungsstarke, preiswerte Bauteile, wie z.B. Magnetrons, als Mikrowellengeneratoren eingesetzt werden können. So kann z.B. bei der Beschichtung kleiner Kalotten mit einem Durchmesser am Kalottenfuß von nicht mehr als 50 mm die von einem einzigen Magnetron gelieferte elektrische Leistung (100 W) ausreichen, um in wenigstens 4 Kalotten die Plasmabereiche zu zünden und aufrechtzuerhalten.

Für die Innenbeschichtung von Reflektoren werden bevorzugt Glassubstrate eingesetzt. Kunststoffsubstrate können zwar prinzipiell ebensogut nach dem erfindungsgemäßen Verfahren beschichtet werden, die meisten Kunststoffe sind jedoch aufgrund ihrer i.a. geringen thermischen Belastbarkeit für die Verwendung als Reflektoren weniger geeignet. Darüber hinaus ist die Haftung der oben beschriebenen Schichtsysteme insbesondere bei Temperaturbelastung auf Glas besser als auf Kunststoff.

Das erfindungsgemäße Verfahren eignet sich wegen der einfacheren Positionierung des Verdrängungskörpers insbesondere für die Beschichtung stark gewölbter Substrate mit rotationssymmetrischer Gestalt, wie z.B. Kalotten oder ellipsoidisch oder parabolisch geformte Körper. Bei entsprechender Formgebung des Verdrängungskörpers können aber ohne weiteres auch unregelmäßig geformte Substrate, z.B. langgestreckte gewölbte Substrate, wie sie z.B. zur Herstellung von Zahnarztspiegeln verwendet werden, beschichtet werden.

Das erfindungsgemäße Verfahren erlaubt, mehrere Substrate gleichzeitig in einem Rezipienten zu beschichten. Zur Beschränkung des Reaktionsraumvolumens ist es dabei zweckmäßig, die Kalotten mit ihren Öffnungen dem Inneren des Reaktionsraums zugewandt in entsprechende Vertiefungen in einer Substrathalterung oder z.B. in der Bodenplatte des Rezipienten zu versenken. Die Deckplatte des Rezipienten kann dann vorteilhafterweise mit einer der Anordnung der Substrate entsprechenden Anordnung von Ausbuchtungen versehen sein, welche sich beim Schließen des Rezipienten als Verdrängungskörper in die von den Substraten begrenzten Hohlräume einsenken. Bevorzugt werden jedoch die Verdrängungskörper zur Einstellung der Dicke der zu reagierenden Gasschicht mittels geeigneter Halterungen zu den zu beschichtenden Fläche im Abstand veränderbar angeordnet. Die frischen und die an Schichtmaterial verarmten Reaktionsgase können bei dieser Anordnung z.B. durch in den Seitenwänden des Rezipienten befindliche Gasein-und -auslaßöffnungen, welche mit einer oder mehreren Gasquellen bzw. einer Vakuumpumpe außerhalb des Rezipienten verbunden sind, in einem kontinuierlichen Gasstrom, im wesentlichen parallel zu den zu beschichtenden Flächen, durch den Rezipienten geführt werden.

Die oben beschriebene Anordnung ist bei kapazitiver Anregung, wobei die Deck- und Bodenplatte des Rezipienten aus einem Metall bestehen, insbesondere auch zum Abscheiden metallischer Schichten oder Mischschichten aus einem Metall und einem Dielektrikum, wobei z.B. der Übergang von einer rein metallischen zu einer rein dielektrischen Schicht auch kontinuierlich erfolgen kann, geeignet.

Zur Hersteilung von Reflektoren mit Kaltlichtspiegeln werden in der Regel durch Pressen geformte Glassubstrate verwendet, welche auf ihrer äußeren gewölbten Oberfläche bereits mit Lampenstutzen, den sog. Kalottenhälsen, für die elektrischen Anschlüsse versehen sind. Vor der Beschichtung werden die Substrate einem Reinigungsprozeß unterzogen, wobei bestimmte Reinigungsverfahren, z.B solche, bei denen die Kalotte von einer Reinigungsflüssigkeit durchströmt wird, es erforderlich machen, den von der Formgebung herrührenden Verschluß am Kalottenhals nach dem Pressen zu entfernen.

Bei der Beschichtung dieser sog. offenen Kalotten kann die Öffnung im Kalottenhals vorteilhaft dazu genutzt werden, jede einzelne Kalotte während des Abscheideprozesses separat mit frischen Reaktionsgasen zu versorgen. Das sonst üblicherweise infolge der zunehmenden Verarmung der Reaktionsgase an Schichtmaterial in Gasflußrichtung auftretende Schichtdickengefälle von Kalotte zu Kalotte wird dadurch vermieden. Die verbrauchten Reaktiongase können durch Öffnungen in den Seitenwänden des Rezipienten abgezogen werden.

Bei geschlossenen Kalotten empfiehlt es sich, jeder einzelnen Kalotte die frischen Reaktionsgase durch entsprechende Kanäle in den Verdrängungskörpern zuzuleiten. Aber auch die offenen Kalotten können auf diese Weise mit frischen Reaktionsgasen versorgt werden.

Bei der gleichzeitigen Beschichtung mehrerer Substrate in einem Rezipienten läßt es sich nicht vermeiden, daß neben den Substraten auch die Wände des Rezipienten mitbeschichtet werden. Dies hat nicht nur einen höheren Verbrauch an Schichtmaterial zur Folge, sondern auch den Nachteil, daß der Rezipient je nach Schichtdicke und Material bei einem Beschichtungsprozeß und je nach den Anforderungen an die Schichtqualität einer aufwendigen Reinigungsprozedur unterzogen werden muß. Diese Reinigung läßt sich nicht immer so gründlich durchführen, daß nicht doch noch Reste der alten Beschichtungen an den Wänden haftenbleiben. Diese Reste können sich im Laufe weiterer Beschichtungsverfahren u. U. von den Wänden lösen und in Form kleiner Partikel auf die zu beschichtenden Substratinnenflächen absetzen und deren Beschichtungen damit unbrauchbar machen.

Um diese Probleme zu vermeiden, wird in einer bevorzugten Verfahrensvariante jedes Substrat einzeln beschichtet und dabei selbst als Teil des Vakuumgefäßes verwendet. Hierzu wird das gewölbte Substrat mit einem entsprechend dimensionierten halbseitig offenen Gefäß, z.B. mit einem an seinem einen Ende zugeschmolzenen Glasrohr, zu einem geschlossenen Gefäß zusammengesetzt und gasdicht verbunden. Für die gasdichte Verbindung reicht es, sofern beide Teile aus Glas bestehen, i.a. aus, die polierten Ränder einfach aneinanderzusetzen und das Gefäß zu evakuieren. Die Abdichtung wird noch verbessert, wenn man zwischen die Ränder der beiden Teilgefäße O-Ringe aus Fluorelastomeren oder Silikongummi legt. Die Verwendung von Dichtungsringen aus organischem Material ist aber auf Substrattemperaturen von maximal ca. 200 °C beschränkt, wobei Fluorkohlenstoffharze und Fluorelastomere Dauertemperaturen bis zu 260 °C widerstehen können.

Während einer Beschichtung wird bei der oben beschriebenen Verfahrensvarianten der Plasmabereich zweckmäßigerweise auf den Kalotteninnenraum beschränkt. Das an die Kalotte angesetzte Gefäßteil wird dadurch nur geringfügig mitbeschichtet und kann entweder ohne oder erforderlichenfalls nach einer einfachen Reinigungsprozedur zur Beschichtung weiterer Kalotten wiederverwendet werden. Da mit jedem Substratwechsel ohnehin jeweils ein Teil des Vakuumgefäßes erneuert wird, ist der Reinigungsaufwand im Vergleich zur Beschichtung eines in einem Rezipienten befindlichen Substrats erheblich herabgesetzt. Um völlig sicherzugehen, daß die Beschichtung nicht doch noch durch sich von der Wand des wiederverwendeten Gefäßteils lösende Beschichtungspartikel beeinträchtigt wird, wird das Vakuumgefäß zweckmäßigerweise so angeordnet, daß sich die Kalotte bei der Beschichtung möglichst senkrecht über dem wiederverwendeten Gefäßteil befindet.

Der Verdrängungskörper, dessen Gestalt auf der der zu beschichtenden Substratfläche zugewandten Seite im wesentlichen der Gestalt der Substratfläche entspricht, ist zweckmäßigerweise an der Wand des an das Substrat angesetzten Gefäßes beabstandet und verschiebbar zu der zu beschichtenden Fläche gehaltert, z.B. mittels eines in die Gefäßwand eingeschmolzenen Glasrohres, welches mit seinem freien, den Verdrängungskörper tragenden Ende auf den Substratinnenraum hin weist. Der Verdrängungskörper kann z.B. auf das Ende des Glasrohres aufgeschraubt oder aufgesteckt sein. Dies hat den Vorteil, daß bei einem Substratwechsel der Abstand des Verdrängungskörpers zu der Substratinnenfläche leicht eingestellt werden kann.

Je nachdem, ob eine Kalotte mit einem geschlossenen oder einem offenen Kalottenhals beschichtet werden soll, ergeben sich für die Führung der Reaktionsgase unterschiedliche Verhältnisse.

Bei der Beschichtung einer geschlossenen Kalotte werden die Reaktionsgase durch eine Gasein- oder -auslaßöffnung in dem an die Kalotte angesetzten Gefäßteil und eine weitere Gasaus- oder -einlaßöffnung in dem Verdrängungskörper auf der der zu beschichtenden Fläche zugewandten Seite, welche über einen Kanal im Verdrängungskörper mit einer Gasquelle bzw. Vakuumpumpe außerhalb des Vakuumgefäßes verbunden ist, in einem kontinuierlichen Gasstrom an der zu beschichtenden Fläche entlanggeführt. Vorteilhafterweise wird dazu der Verdrängungskörper so gehaltert, daß sich der Kanal in dem Verdrängungskörper in dem nach außen führenden, den Verdrängungskörper tragenden Glasrohr fortsetzt.

Es ist strömungstechnisch günstig, die Gasflußrichtung so zu wählen, daß die frischen Reaktionsgase durch den Kanal im Verdrängungskörper in den Reaktionsraum eingeleitet und die an Schichtmaterial verarmten Reaktionsgase durch eine Gasauslaßöffnung in dem an die Kalotte angesetzten Gefäßteil abgeführt werden. Bei der umgekehrten Gasflußrichtung ist es wegen des Druckabfalls in der Düse des Verdrängungskörpers schwierig, in dem Rezipienten den für die Beschichtung erforderlichen, niedrigen Druck aufrechtzuerhalten.

Die oben beschriebene Gasflußrichtung empfiehlt sich insbesondere auch dann, wenn Substrate mit nicht rotationssymmetrischer Gestalt beschichtet werden sollen. Da es in diesem Fall sehr schwierig ist, an jeder Stelle der zu beschichtenden Fläche gleiche Strömungsverhältnisse für die Reaktionsgase zu schaffen, ist es zur Erzielung einer gleichmäßigen Beschichtung zweckmäßig, die frischen Reaktionsgase über eine Vielzahl von Gaseinlaßöffnungen, welche gleichmäßig über die der zu beschichtenden Fläche gegenüberliegende Stirnfläche des Verdrängungskörpers verteilt sind und über einen zentralen Kanal im Verdrängungskörper mit einer Gasquelle außerhalb des Vakuumgefäßes verbunden sind, in den Reaktionsraum einzuleiten.

Besonders einfach werden die Verhältnisse bei der Beschichtung von offenen Kalotten. In diesem Fall muß der Gasstrom nicht durch den Verdrängungskörper geleitet werden, sondern es ist möglich, den offenen Kalottenhals selbst an geeignete Zuleitungen zu einer Gasquelle bzw. einer Vakuumpumpe anzuschließen. Für die Gasflußrichtung gibt es bei dieser Ausführungsform keine Vorzugsrichtung.

Es kann vorteilhaft sein, bei "offenen" Kalotten den Kalottenhals zu verschließen und die Beschichtung analog zu den geschlossenen Kalotten vorzunehmen. Die Vorrichtung zur Beschichtung geschlossener Kalotten kann einfacher für die Massenproduktion hochskaliert werden, da jedes Vakuumgefäß mit nur einer einzigen Dichtung versehen werden muß.

Bei nicht zu großen "offenen" Kalotten, z.B. mit einem Durchmesser von maximal 20 mm am Kalottenfuß, ist das Reaktionsraumvolumen i.a. noch klein genug, daß die Beschichtung noch ohne Verdrängungskörper erfolgen kann. Nach der Erfindung ist für diesen Fall vorgesehen, die Beschichtung in einem Rezipienten durchzuführen, der sich aus zwei zu einem Vakuumgefäß zusammengefügten und gasdicht miteinander verbundenen Kalotten zusammensetzt. Die Reaktionsgasstrom wird dabei durch die offenen Kalottenhälse geführt. Bei dieser Verfahrensvarianten wird die Beschichtung bei Durchführung eines Impulsverfahrens um so gleichmäßiger, je mehr die Gestalt der Substrate der einer Halbkugel entspricht.

Bei dem erfindungsgemäßen Verfahren können die bei PCVD-Verfahren üblichen Substrattemperaturen eingestellt werden. Grenzen sind dabei in erster Linie durch die Temperaturbeständigkeit des Substratmaterials gesetzt. Es ist bekannt, daß höhere Substrattemperaturen eine größere Dichte des abgeschiedenen Materials bewirken und daher bevorzugt dann eingesetzt werden, wenn besondere Anforderungen an die mechanische, thermische und chemische Stabilität der Schichten gestellt werden.

Bei der Beschichtung von Kalotten zur Herstellung von Reflektoren werden bevorzugt Substrattemperaturen zwischen Raumtemperatur und 200 °C eingestellt. Die Schichtqualität ist damit für die Verwendung als Reflektoren ausreichend gut und das Verfahren arbeitet wirtschaftlich. Ein weiterer Vorteil liegt darin, daß sich Substrattemperaturen in dieser Größenordnung ohne Zusatzheizung allein durch eine üblicherweise vor der eigentlichen Beschichtung zum Konditionieren der zu beschichtenden Substratfläche eingesetzten Plasmavorbehandlung, z.B. eine O₂-Gasentladung, einstellen lassen. Die Dauer der Plasmavorbehandlung bestimmt dabei die Höhe der erreichten Substrattemperatur.

Der Verdrängungskörper ist zweckmäßigerweise aus einem Material gefertigt, das wenigstens bis zur gewählten Substrattemperatur formstabil und vakuumtauglich ist. Vakuumtauglich bedeutet in diesem Zusammenhang, daß bei der gewählten Substrattemperatur aus dem Material keine den Prozeß negativ beeinflussende Ausgasung stattfinden darf. Dies bezieht sich sowohl auf eine mögliche Druckverschlechterung als auch auf die Anreicherung der Atmosphäre in dem Rezipienten mit einer die Schichtqualität verschlechternden Spezies.

Für die oben beschriebene Beschichtung reicht es aus, wenn der Verdrängungskörper aus einem Material besteht, das bis zu einer Temperatur von etwa 200 °C formstabil und vakuumtauglich und resistent gegen die in der Entladung vorkommenden Spezies ist. Materialien, die diesen Anforderungen genügen, sind z.B. metallische Werkstoffe, wie z.B. Al, Ti, Edelstahl, oder dielektrische Materialien, wie z.B. Glas, Keramik, Glaskeramik, oder sogar Kunststoffe, insbesondere Fluorkohlenstoffharte, bevorzugt Polytetrafluorethylen.

Die Beschichtung wird bevorzugt bei einem Druck im Rezipienten von 0,03 bis 10 mbar durchgeführt. Bei einem Druck von weniger als 0,03 mbar nimmt die Beschichtungsrate so stark ab, daß das Verfahren nicht mehr wirtschaftlich arbeitet. Außerdem ist u.U. das Plasma nicht ausreichend stabil, so daß die aufwendigeren magnetfeldgestützen Verfahren verwendet werden müssen. Ein hoher Druck ist zwar hinsichtlich der Beschichtungsrate vorteilhaft, allerdings steigt mit zunehmendem Druck die Wahrscheinlichkeit für das Auftreten der Homogenreaktion, so daß der Abstand zwischen Verdrängungskörper und Substrat entsprechend verkleinert werden muß. Es hat sich als zweckmäßig erwiesen, den Druck nicht über 10 mbar hinaus zu erhöhen, um nicht mit zu kleinen Abständen arbeiten zu müssen.

Bei PCVD-Verfahren wird das Plasma üblicherweise mit so niedriger Leistung erzeugt, daß nur etwa 1 bis 4 % des Reaktionsgases in Schichtmaterial umgesetzt werden. Diese Ausbeute stellt einen Kompromiß zwischen der Wirtschaftlichkeit des Verfahrens und der Gefahr einer ungleichmäßigen Beschichtung infolge einer zu starken Verarmung des Reaktionsgases an Schichtmaterial beim Entlangführen über die zu beschichtende Fläche dar.

Bevorzugt wird die Beschichtung mit einem Plasmaimpuls-CVD-Verfahren durchgeführt, wobei in an sich bekannter Weise die Dicke der auf ein Flächenelement Substratfläche bei einem Plasmaimpuls abgeschiedenen Schicht an jeder Stelle des Substrats durch die Zahl der in dem Gasvolumen über dem Flächenelement befindlichen schichtbildenden Teilchen bestimmt wird. Damit läßt sich nicht nur eine bessere Ausnutzung der Reaktionsgase, bis hin zur vollständigen Verarmung an Schichtmaterial während eines Plasmaimpulses, und daraus resultierend eine sehr viel höhere Abscheiderate als beim Dauerstrichverfahren erzielen, das Plasmaimpuls-CVD-Verfahren hat noch den weiteren Vorteil, daß bei entsprechender Formgebung bzw. Anordnung des Verdrängungskörpers ein vorgegebenes axiales und azimutales Schichtdickenprofil erzeugt werden kann.

So ist z.B. bei der Verwendung der Kalotten als Reflektoren i.a. erwünscht, daß bei Draufsicht auf die Kalotte von vorne über die gesamte Reflektorfläche, trotz unterschiedlicher Einfallswinkel des von einer zentral in der Kalotte angeordneten Lichtquelle abgegebenen Lichts, ein einheitlicher Reflexionsfarbton entsteht.

Unter Berücksichtigung der Tatsache, daß die zu einem bestimmten Reflexionsfarbton führenden Interferenzerscheinungen vom optischen Weg des Lichts beim Durchgang durch die einzelnen Schichten des dielektrischen Schichtsystems abhängig sind, kann das zur Erzeugung einer einheitlichen Reflexionsfarbe erforderliche Schichtdickenprofil in Abhängigkeit von der Gestalt der Substratinnenfläche leicht über einfache geometrische Beziehungen ermittelt werden und in ein "Abstandsprofil" zwischen der Substratinnenfläche und dem Verdrängungskörper, dessen Gestalt auf der der zu beschichtenden Substratfläche zugewandten Seite im wesentlichen der Gestalt der Substratfläche entspricht, umgesetzt werden. Dabei empfiehlt es sich, den Druckverlust der Reaktionsgase in Strömungsrichtung bei der Ermittlung des Abstandsprofils zu berücksichtigen.

Die mit der Erfindung erzielbaren Vorteile bestehen insbesondere darin, daß ein erprobtes und für seine Vorteile bekanntes Beschichtungsverfahren, das Plasma-CVD-Beschichtungsverfahren, nunmehr auch zur Innenbeschichtung stark gewölbter Substrate, z.B. zur Herstellung von Reflektoren, eingesetzt werden kann. Durch Verwendung eines PCVD-Verfahrens ist es möglich, nahezu beliebig geformte, stark gewölbte Substrate ohne Substratbewegung mit einer gleichmäßigen Beschichtung von hoher optischer Qualität sowie mechanischer, chemischer und thermischer Stabilität zu versehen, wobei bei Verwendung eines Plasmaimpulsverfahrens durch entsprechende Formgebung des Verdrängungskörpers, dessen Gestalt auf der zu beschichtenden Substratfläche zugewandten Seite im wesentlichen der Gestalt der Substratfläche entspricht, ein vorgegebenes axiales und azimutales Schichtdickenprofil aufgeprägt werden kann.

Bei der Einzelbeschichtung eines Substrats wird außer dem Substrat, das gleichzeitig noch Teil des Reaktionsgefäßes ist, und dem Verdrängungskörper praktisch keine weitere Fläche beschichtet. Die Beschichtung kann in einem leicht beherrschbaren und kostengünstigen Druckbereich stattfinden. Die Umsetzung der Reaktionsgase in Schichtmaterial kann praktisch vollständig sein, woraus nicht nur eine bestmögliche Ausnutzung der Reaktionsgase, sondern auch noch hohe Beschichtungsraten resultierten. Eine örtliche Ungleichmäßigkeit des Anregungsfeldes, z.B. des Mikrowellenfeldes, muß beim Plasmaimpulsverfahren nicht zu einer Abweichung der Schichtdicke vom Sollwert führt, sofern die Feldstärke einen (leicht ermittelbaren) Schwellenwert, bei dem die Umsetzung in Schichtmaterial ihren Maximalwert erreicht, überschreitet.

Die Erfindung und die erzielbaren Vorteile werden im folgenden anhand von beispielhaften schematischen Zeichnungen und zwei Ausführungsbeispielen näher beschrieben.

Es zeigen:
Figur 1 in einer schematischen Längsschnittdarstellung eine Vorrichtung zur Beschichtung mehrerer Kalotten in einem Rezipienten mit einem Plasmaimpulsverfahren nach der Erfindung;
Figur 2 in der gleichen Darstellungsweise eine Vorrichtung zur Beschichtung einer einzelnen Kalotte mit geschlossenem Kalottenhals;
Figur 3 eine Vorrichtung zur Beschichtung einer einzelnen Kalotte mit offenem Kalottenhals;
Figur 4 einen Verdrängungskörper, der zur Beschichtung eines nicht rotationssymmetrisch geformten Substrats als Gasdusche ausgebildet ist;
Figur 5 die Vorrichtung aus Figur 2, wobei die Kalotte zur Vermeidung von Schäden durch Leckagen von einem weiteren Vakuumgefäß umgeben ist und
Figur 6 zwei kleine, halbkugelförmige Kalotten, die zur Beschichtung ohne Verdrängungskörper zu einem Vakuumgefäß zusammengefügt sind.

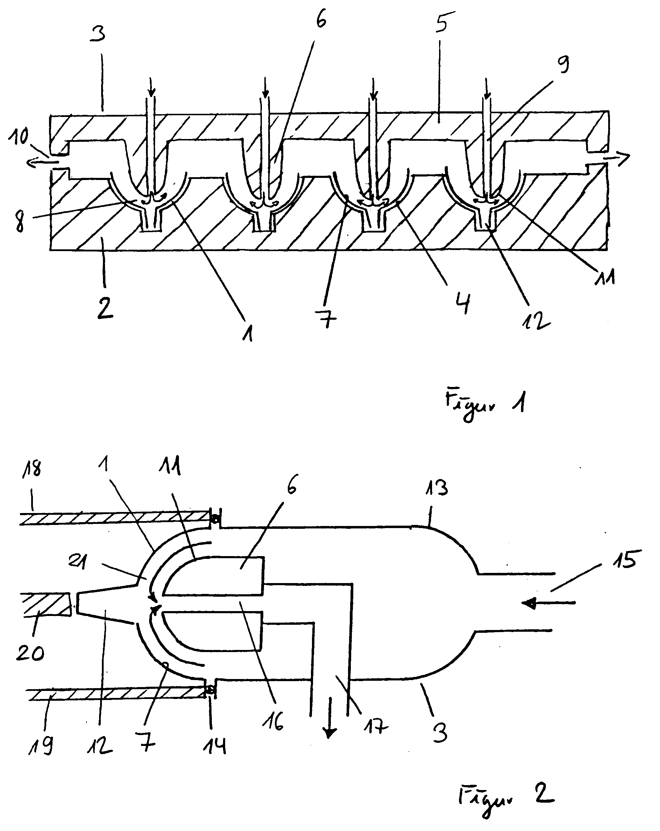

Man erkennt in Figur 1 mehrere Kalotten 1, die zur Beschichtung mit einem Plasmaimpulsverfahren auf der Bodenplatte 2 eines Rezipienten 3 in einem Raster nebeneinander angeordnet sind. Um das Reaktionsraumvolumen möglichst klein zu halten, sind die Kalotten 1 in entsprechende Vertiefungen 4 in der Bodenplatte 2 eingesenkt. Die Deckplatte 5 des Rezipienten 3 ist entsprechend der Anordnung der Vertiefungen 4 in der Bodenplatte 2 mit einer Anordnung von Verdrängungskörpern 6 versehen, welche in die von den zu beschichtenden Kalotteninnenflächen 7 begrenzten Hohlräume 8 eintauchen. Jeder Verdrängungskörper 6, dessen Gestalt auf der der zu beschichtenden Substratfläche zugewandten Seite im wesentlichen der Gestalt der Substratfläche entspricht, ist zum Zuführen der Reaktionsgase mit einem zentralen Kanal 9 versehen, welcher mit einer in der Figur nicht dargestellten Gasquelle verbunden werden kann. In den Seitenwänden des Rezipienten 3 sind mehrere Gasauslaßöffnungen 10 vorgesehen, durch welche die an Schichtmaterial verarmten Reaktionsgase mittels einer nicht dargestellten Vakuumpumpe abgesaugt werden können.

Der Abstand zwischen einer Kalotteninnenflächen 7 und der dieser gegenüberliegenden Seite 11 des zugehörigen Verdrängungskörper 6 ist so bemessen, daß die in dem Gasraum zwischen den beiden Flächen während einer Plasmaentladung stattfindende Partikelbildung die Schichtqualität nicht beeinträchtigt. Darüber hinaus sind bei der dargestellten Ausführungsform zum Ausgleich des Druckgefälles der Reaktionsgase in Strömungsrichtung zur Erzeugung einer gleichmäßigen Beschichtung die Verdrängungskörper 6 am gasausgangsseitigen Ende einer jeden Kalotte 1, d.h. am Kalottenrand, weiter beabstandet angeordnet als am gaseingangsseitig gelegenen Kalottenhals.

Die Mittel zur Erzeugung der Plasmazone in dem Rezipienten sind an sich bekannt und daher in der Figur nicht dargestellt. So kann die Anregung des Plasmas z.B. kapazitiv in der Weise erfolgen, daß sowohl die Boden- als auch die Deckplatte des Rezipienten aus einem Metall bestehen und zwischen beiden Platten eine Spannung angelegt wird. Bei dieser Anordnung können sowohl dielektrische als auch metallische Schichten oder Mischschichten aus dielektrischen und metallischen Materialien abgeschieden werden. Ebensogut ist es möglich, über der Deck- bzw. unter der Bodenplatte aus einem dielektrischen Material eine Anordnung von Mikrowellenantennen anzubringen und das Plasma durch Einstrahlen von Mikrowellenenergie zu zünden und aufrechtzuerhalten.

Zur Durchführung des Beschichtungsverfahrens werden die Reaktionsgase durch die Verdrängungskörper 6 in einem kontinuierlichen Gasstrom in die von den Kalotteninnenflächen 7 und den Verdrängungskörpern 6 begrenzten Hohlräume 8 eingeleitet. Der Gasstrom wird dabei nach Eintritt in den von der Kalotte begrenzten Hohlraum am Kalottenhals 12 umgelenkt und entlang der zu beschichtenden Fläche seitlich am Verdrängungskörper 6 vorbei aus der Kalotte 1 wieder heraus geführt (die durchgezogen gezeichneten Pfeile in der Figur geben die Gasflußrichtung an). Durch Anregen einer Gasentladung wird auf der Kalotteninnenfläche 7, der Oberfläche des Verdrängungskörpers 6 und auf der gesamten Innenwand des Rezipienten 3 Schichtmaterial abgeschieden. Die Zeitdauer zwischen zwei Plasmaimpulsen und der Gasmassenfluß sind zweckmäßigerweise, wie bei Plasmaimpuls-CVD-Verfahren üblich, so aufeinander abgestimmt, daß der Reaktionsraum über der Kalotteninnenfläche vor jedem Plasmaimpuls wieder vollständig mit frischen Reaktionsgasen aufgefüllt ist.

Durch Änderung der Gaszusammensetzung können in an sich bekannter Weise Einzelschichten mit unterschiedlichen Zusammensetzungen übereinander abgeschieden werden.

Zur Heizung der Substrate kann die Vorrichtung aus Figur 1 in einen Ofen eingebaut werden. Einfacher ist es, die Substrate mittels einer Plasmavorbehandlung auf die gewünschte Substrattemperatur zu bringen.

Die Figuren 2 und 3 zeigen Vorrichtungen zur Beschichtung einzelner Kalotten. Man erkennt, daß jeweils eine Kalotte 1 mit einem halbseitig offenen Gefäß 13 zu einem Rezipienten 3 zusammengefügt ist. Für eine gasdichte Verbindung sorgt ein zwischen den Rändern der beiden Gefäßteile befindlicher Dichtungsring 14.

Die Vorrichtung in Figur 2 eignet sich zur Beschichtung einer Kalotte mit geschlossenem Kalottenhals. Die Zuführung der Reaktionsgase erfolgt durch eine Gaseinlaßöffnung 15 in dem an die Kalotte angesetzten Gefäßteil 13.

Die Reaktionsgase werden an dem Verdrängungskörper 6, dessen Gestalt auf der der zu beschichtenden Substratfläche zugewandten Seite im wesentlichen der Gestalt der Substratfläche entspricht, vorbei, an der zu beschichtenden Fläche entlang zum Kalottenhals 12 geführt, dort umgelenkt und über den Kanal 16 im Verdrängungskörper 6 und das den Verdrängungskörper 6 tragende abgewinkelte Glasrohr 17, welches mit einer nicht dargestellten Vakuumpumpe in Verbindung steht, abgesaugt. Zur Halterung des Verdrängungskörpers kann auch ein gerades, in dem Vakuumgefäß axial angeordnetes Glasrohr, das in die der Kalotte gegenüberliegende Gefäßwand eingeschmolzen ist, verwendet werden. Die Gaszufuhr kann in diesem Fall z.B. durch um die Einschmelzstelle herum gruppierte Gaseinlaßöffnungen erfolgen. Die oben beschriebene Gasflußrichtung ist dann vorteilhaft, wenn ein Zusetzten des Kanals 16 mit Schichtmaterial befürchtet werden muß.

Die Anregung des Plasmas erfolgt bei der dargestellten Vorrichtung durch Einstrahlen von Mikrowellenenergie. Zu diesem Zweck wird auf die Kalotte 1 ein Hohlleiter 18 aufgesetzt, dessen Außenleiter 19 sich bis zum Kalottenrand erstreckt und dessen Innenleiter 20 unmittelbar vor dem geschlossenen Kalottenhals 12 endet. Mit dieser Anordnung läßt sich der Plasmabereich leicht auf den von der Kalotteninnenfläche 7 und der Stirnfläche 11 des Verdrängungskörpers 6 begrenzten Reaktionsraum 21 beschränken. Der Plasmabereich erstreckt sich dabei zwar teilweise noch bis in den Kanal 16 im Verdrängungskörper hinein; dadurch, daß aber durch diesen Kanal nur die an Schichtmaterial verarmten Reaktionsgase geführt werden, wird ein allmähliches Zusetzen der Öffnung und des Kanals mit Schichtmaterial weitgehend vermieden.

Die Beschichtung wird im übrigen wie oben beschrieben durchgeführt.

Figur 3 zeigt eine Vorrichtung zur Beschichtung einer Kalotte mit offenem Kalottenhals. Die Beschichtung erfolgt bei dieser Ausführungsform im wesentlichen analog zur Ausführungsform in Figur 2. Ein Unterschied besteht darin, daß die verbrauchten Reaktionsgase nicht durch den Verdrängungskörper 6, sondern durch den offenen Kalottenhals 12 abgeführt werden. Zu diesem Zweck ist von außen auf die Kalotte 1 ein Glasrohr 22, welches mit einer Vakuumpumpe in Verbindung steht, aufgesetzt und mittels eines Dichtungsringes 14 gegen den Außenraum sicher abgedichtet. Die Anregung des Plasmas kann z.B. durch Einstrahlen von Mikrowellenenergie (s. gestrichelt gezeichnete Pfeile) mittels nicht dargestellter seitlich um die Kalotte herum gruppierter Mikrowellenantennen erfolgen.

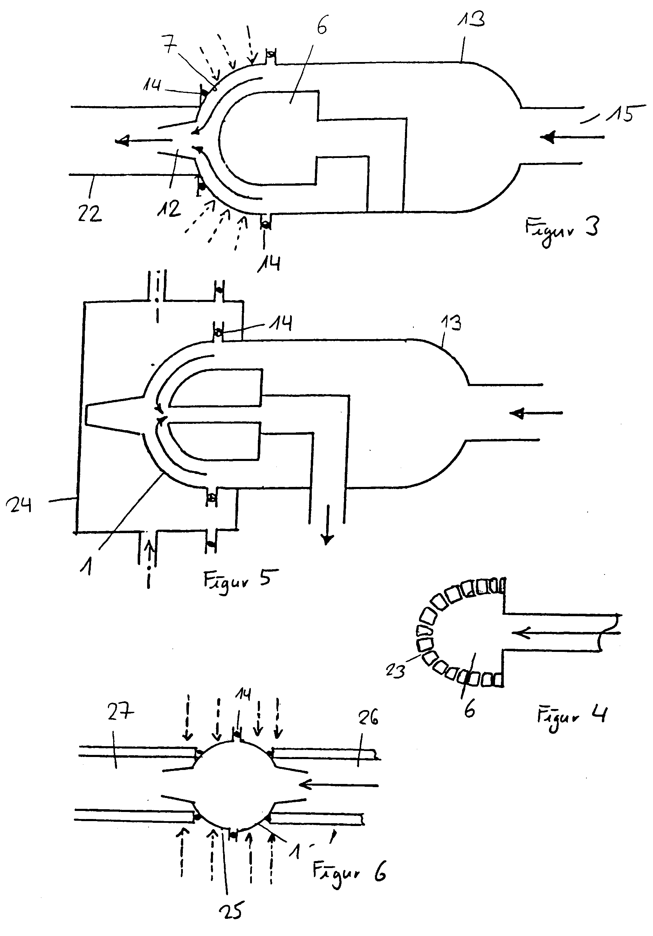

Der Verdrängungskörper 6 in Figur 2 muß nicht zwingend einen zentralen Kanal 16 aufweisen, sondern kann, wie in Figur 4 dargestellt, mit gleichmäßig über die gesamte Fläche verteilten, kleinen Kanälen 23 (⌀ ≲ 1 mm) versehen sein (z.B. Fritte).

Um Ausfälle durch Leckagen an der Kalottendichtung 14 zu vermeiden, kann es günstig sein, wie in Figur 5 dargestellt, über der Kalotte ein zweites Vakuumgefäß 24 zu installieren, welches mit einem Gas, das weder das Kalottenmaterial angreift, noch in einem Plasma selbst an der Beschichtung teilnimmt (z.B. O₂), beaufschlagt wird. Bei unveränderter Größe des Lecks wird die in die Kalotte 1 strömende Gasmenge um so kleiner sein, je kleiner der Druckunterschied zwischen Innen- und Außenseite der Kalotte ist. Vorteilhafterweise wird der Druck im Vakuumgefäß 24 gerade so hoch eingestellt, daß bei der Plasmabeschichtung der Kalotteninnenfläche 7 dort gerade noch kein Plasma gezündet wird (p ≈ 50 bis 100 mbar).

Wichtig kann die oben beschriebene Maßnahme sein, wenn aus demselben Gasversorgungssystem viele Kalotten gleichzeitig beschichtet werden. Ohne diese Maßnahme kann durch ein einziges Leck die Beschichtung aller Kalotten gefährdet werden.

Man erkennt in Figur 6 zwei kleine, halbkugelförmige Kalotten 1, die zu einem Vakuumgefäß 25 zusammengefügt sind. Durch die Kugelgestalt des Vakuumgefäßes 25 befindet sich über jedem Flächenelement Substratfläche die gleiche Gasmenge. Eine gleichmäßige Beschichtung ist bei Anwendung eines Plasmaimpuls-CVD-Verfahrens somit auch ohne Verdrängungskörper gewährleistet. Das durch die beiden Kalotten begrenzte Volumen ist klein genug, um eine Beeinträchtigung der Schichtqualität durch eine Homogenreaktion im Gasraum ausschließen zu können.

Der Gasfluß erfolgt bei der dargestellten Ausführungsform durch die offenen Kalottenhälse 12, an die analog zur Vorrichtung in Figur 3 Gaszu-und Ableitungsrohre 26, 27 gasdicht angesetzt sind. Die Anregung des Plasmas kann auch bei dieser Varianten in einfacher Weise durch Einstrahlen von Mikrowellenenergie mittels seitlich um das Vakuumgefäß herum gruppierter Mikrowellenantennen erfolgen.

Wie aus den Figuren leicht ersichtlich ist, sind die Beschichtungs- und Verdrängungskörper prinzipiell miteinander austauschbar. So kann zum Beispiel bei der in Figur 3 dargestellten Ausführungsform für eine Außenbeschichtung die zu beschichtende Kalotte an die Stelle des Verdrängungskörpers gebracht werden. Es muß nur dafür gesorgt werden, um eine gleichzeitig mit der Außenbeschichtung erfolgende Innenbeschichtung zu vermeiden, daß sich im Kalotteninnenraum kein Schichtmaterial befindet. Die Kalotte kann dazu zum Beispiel Teil eines weiteren in dem Rezipienten angeordneten Vakuumgefäßes sein.

Für die Beschichtung von Kalotten in Massenproduktion ist insbesondere die in Figur 2 dargestellte Vorrichtung geeignet, da das Vakuumgefäß nur eine einzige Dichtung besitzt. Es empfiehlt sich, mehrere der an die Kalotten angesetzten Gefäße fest nebeneinander, in einem Raster angeordnet, zu installieren. Die Gaszuführung wie auch der Anschluß an eine Vakuumpumpe kann über gemeinsame Zuleitungssysteme erfolgen.

Zur Beschichtung werden die Kalotten auf die fest installierten Gefäßhälften aufgesetzt, ggf. wird eine Dichtungsring verwendet, und die so gebildeten Vakuumgefäße evakuiert. Die Anregung des Plasmas kann in einfacher Weise durch Einstrahlen von Mikrowellenenergie erfolgen, z.B. mittels von oben auf die Kalotten aufgesetzte Hohlleiter. Nach der Beschichtung werden die Vakuumgefäße belüftet, woraufhin die beschichteten Kalotten einfach abgehoben und durch neue Substrate ersetzt werden können.

### 1. Beispiel

Eine Kalotte aus Borosilikatglas Nr. 8486 der Firma Schott Glaswerke, mit einem Durchmesser von 5 cm liegt mit dem Preßrand auf einem Rohr von ebenfalls 5 cm Durchmesser. Ein auf dem polierten Rohrende liegender O-Ring aus Viton sorgt für eine vakuumdichte Verbindung zwischen Rohr und Kalotte. Das Rohr ist aus einem dielektrischen Material, im vorliegenden Fall aus Borosilikatglas Nr. 8330 der Firma Schott Glaswerke gefertigt. Durch ein seitlich eingeschmolzenes Glasrohr mit 10 mm Durchmesser können die Reaktionsgase in den so gebildeten Reaktionsraum geführt werden. Durch eine Verjüngung am Rohrende werden die verbrauchten Reaktionsgase abgeführt. Maße können der Figur 2 entnommmen werden, die im Maßstab 1:1 ausgeführt ist. Das Gaszuführrohr ist auf der Achse des größeren Rohres abgewinkelt; es wird mit einem axial durchbohrten Verdrängungskörper aus Teflon abgeschlossen. Der Durchmesser der Bohrung beträgt 5 mm, dieser Wert ist jedoch nicht sehr kritisch. Durch diese Bohrung können die Reaktionsgase in den Reaktionsraum eintreten. Der Verdrängungskörper ist so geformt, daß der Abstand seiner Oberfläche zur inneren Oberfläche der Kalotte - bis auf den Bereich unter dem Kalottenhals - überall gleichgroß ist, nämlich 7 mm.

Vor der Beschichtung wird in dem durch Kalotte und Verdrängungskörper gebildeten Reaktionsraum eine O₂-Gasentladung gezündet, um die zu beschichtende Kalotteninnenfläche zu konditionieren. Über die Intensität und Dauer dieser O₂-Gasentladung wird die gewünschte Substrattemperatur eingestellt. Die Mikrowellenenergie wird von einer Mikrowellenantenne von oben auf die Kalotte abgestrahlt.

Nachfolgend sind die Parameter zur O₂-Gasentladung angegeben:

| | |
|---|---|
| O₂-Massenfluß (ml/min) | 200 |
| Druck im Rezipienten (mbar) | 0,7 |
| Impulsdauer (ms) | 0,6 |
| Impulspause (ms) | 20 |
| Mikrowellenfrequenz (GHz) | 2,45 |
| Mittlere Mikrowellenleistung (W) | 75 |
| Substrattemperatur (°C) | 90 |

Anschließend wird die Mikrowelleneinstrahlung unterbrochen und die Gasmischung zur Herstellung der ersten TiO₂-Schicht eingestellt. Diese Gasmischung wird zunächst etwa 0.5 min in die Bypass-Leitung fließen gelassen; dann sind die Massenflüsse stationär. Während dieser Zeit kühlt die Kalotte nur unwesentlich ab.

Die Herstellung der TiO₂-Schicht erfolgt mit den Parametern:
TiCl₄-Massenfluß (ml/min): 3
Beschichtungszeit für eine λ/4-Schicht für λ = 550 nm (s): 25
die übrigen Parameter sind gegenüber denen der O₂-Gasentladung unverändert.

Anschließend wird die Mikrowelleneinstrahlung unterbrochen und die Gasmischung zur Herstellung der ersten SiO₂-Schicht eingestellt; bei stationärem Massenfluß (s.o.) erfolgt die Herstellung der SiO₂-Schicht.

Die Verfahrensparameter sind wie folgt:
C₆H₁₈OSi₂-Massenfluß (ml/min): 3,6
Beschichtungszeit für eine λ/4-Schicht für λ = 550 nm (s): 25
die übrigen Parameter sind gegenüber denen der O₂-Gasentladung unverändert.

Es werden abwechselnd insgesamt 31 TiO₂/SiO₂- λ/4-Schichten aufgebracht und deren Dicken nach bekannten optischen Kriterien so eingestellt, daß das entstandene Interferenzschichtsystem ein sog. Kaltlichtspiegel ist.

### 2. Beispiel

Eine Kalotte aus Borosilikatglas Nr. 8486 der Firma Schott Glaswerke mit einem Durchmesser von 50 mm liegt in einem Rezipienten auf der unteren Elektrode eines 13.56 MHz-Plasmagenerators. Die obere Elektrode ist als Gasdusche und Verdrängungskörper ausgebildet. Der Abstand des Verdrängungskörpers zu der zu beschichtenden Substratinnenfläche beträgt an jeder Stelle des Substrats 15 mm.

Der Rezipient wird auf 0.03 mbar evakuiert und die Kalotte bei diesem Druck mit einer O₂-Gasentladung vorbehandelt. Anschließend wird bei gleichem Druck beschichtet; dazu wird ein Massenfluß von 1 ml/min TiCl₄ und 35 ml O₂ eingestellt und bei einer HF-Leistung von 50 W eine TiO₂-Schicht aufgebracht. Dann wird ein Massenfluß von 0.5 ml/min C₆H₁₈OSi₂ (Hexamethyldisiloxan) und 35 ml O₂ eingestellt und bei einer HF-Leistung von 50 W eine SiO₂-Schicht aufgebracht.

Es werden abwechselnd 31 TiO₂/SiO₂- λ/4-Schichten aufgebracht, deren Schichtdicken nach bekannten optischen Kriterien so eingestellt werde, daß das Interferenzschichtsystem ein Kaltlichtspiegel ist.

## Patentansprüche

1. PCVD-Verfahren zur Herstellung eines auf der Innen- und/oder Außenfläche (7) mit einem dielektrischen und/oder metallischen Schichtsystem versehenen, im wesentlichen kalottenförmigen Substrats (1), insbesondere eines Reflektors mit innenseitiger dielektrischer Kaltlichtspiegelbeschichtung,
**dadurch gekennzeichnet,**
daß man mit Hilfe eines Verdrängungskörpers (6), dessen Gestalt auf der der zu beschichtenden Substratfläche (1) zugewandten Seite (11) im wesentlichen der Gestalt der Substratfläche entspricht, die Dicke der zu reagierenden Gasschicht über der zu beschichtenden Fläche (7) des Substrats so einstellt, daß das Ausmaß der in der Gasschicht während der Plasmaphase auftretenden Homogenreaktion ("Glasrußbildung") für die gewünschte Schichtqualität unschädlich bleibt.

2. Verfahren nach Anspruch 1,
**dadurch gekennzeichnet,**
daß man die Dicke der zu reagierenden Gasschicht auf 2 bis 20 mm einstellt.

3. Verfahren nach Anspruch 1 oder 2,
**dadurch gekennzeichnet,**
daß man die Dicke der zu reagierenden Gasschicht mittels eines Verdrängungskörpers (6) aus einem Material, das bis zu einer Temperatur von 200 °C formstabil und vakuumtauglich ist, einstellt.

4. Verfahren nach Anspruch 3,
**dadurch gekennzeichnet,**
daß man die Dicke der zu reagierenden Gasschicht mittels eines Verdrängungskörpers (6) aus einem Metallwerkstoff, insbesondere Al, Ti, Edelstahl, oder einem dielektrischen Werkstoff, insbesondere Glas, Keramik, Glaskeramik oder aus einem Kunststoff, insbesondere einem Fluorkohlenstoffharz, einstellt.

5. PCVD-Verfahren zur Herstellung eines auf der Innenfläche (7) mit einem dielektrischen Schichtsystem versehenen im wesentlichen kalottenförmigen Substrat (6) mit einem offenen Kalottenhals (12) und einem Durchmesser am Kalottenfuß von weniger als 2 cm, insbesondere eines Reflektors mit innenseitiger Kaltlichtspiegelbeschichtung,
**dadurch gekennzeichnet,**
daß man die Beschichtung in einem Rezipienten, welcher aus zwei zu einem Vakuumgefäß (25) zusammengesetzten und gasdicht miteinander verbundenen Substraten (1) besteht, durchführt, wobei man die Reaktionsgase durch die Öffnungen in den Kalottenhälsen in einem kontinuierlichen Gasstrom an den zu beschichtenden Flächen entlangführt und das Plasma in dem gesamten durch die beiden Substrate (1) begrenzten Reaktionsraum erzeugt.

6. Vorrichtung zur Durchführung des Verfahrens nach wenigstens einem der Ansprüche 1 bis 4,
**gekennzeichnet durch**
ein Vakuumgefäß (3),
Mittel zur Halterung eines oder mehrerer im wesentlichen kalottenförmiger Substrate (1) in dem Vakuumgefäß (3), einen oder mehrere Verdrängungskörper (6), welcher(e) in dem Vakuumgefäß (3) zur Begrenzung der Dicke der zu reagierenden Gasschicht beabstandet und verschiebbar zu der(n) zu beschichtenden Fläche(n) (7) angeordnet ist (sind) und dessen (deren) Gestalt auf der der zu beschichtenden Fläche (7) zugewandten Seite (11) im wesentlichen der Gestalt der Substratfläche (7) entspricht(sprechen),
Gasein- bzw. -auslaßöffnungen in dem Vakuumgefäß (3), welche mit einer Gasquelle bzw. einer Vakuumpumpe verbunden sind und die so angeordnet sind, daß die Reaktionsgase in einem kontinuierlichen Gasstrom an der(n) zu beschichtenden Fläche(n) entlangführbar sind, sowie Mittel zur Anregung einer Plasmazone in der zu reagierenden Gasschicht.

7. Vorrichtung zur Durchführung des Verfahrens nach wenigstens einem der Ansprüche 1 bis 4, zur Innen- und/oder Außenbeschichtung eines einzelnen Substrats (1),
**gekennzeichnet durch**
ein Vakuumgefäß (3), welches durch das gewölbte, im wesentlichen kalottenförmige Substrat (1) und ein mit diesem an den Rändern zusammengesetztes und gasdicht verbundenes, halbseitig offenes Gefäßteil (13) gebildet wird,
einen Verdrängungskörper (6) welcher zur Begrenzung der zu reagierenden Gasschicht in dem Vakuumgefäß (3) beabstandet und verschiebbar zu der zu beschichtenden Fläche (7) angeordnet ist und dessen Gestalt auf der der zu beschichtenden Fläche (7) zugewandten Seite (11) im wesentlichen der Gestalt der Substratfläche (7) entspricht,
Mittel zur Halterung des Verdrängungskörpers (6) in dem Gefäßteil (13), einen Kanal (16) in dem Verdrängungskörper (6), welcher auf der der zu beschichtenden Fläche zugewandten Seite (11) des Verdrängungskörpers (6) in mindestens eine Gasein- bzw. -auslaßöffnung mündet,
Mittel, welche den Kanal (16) mit einer Gasquelle bzw. einer Vakuumpumpe außerhalb des Vakuumgefäßes (3) verbinden,
mindestens eine weitere Gasein- bzw. -auslaßöffnung in dem Gefäßteil (13), welche mit einer Gasquelle bzw. Vakuumpumpe verbunden ist und die zusammen mit der Gasein- bzw. -auslaßöffnung in dem Verdrängungskörper (6) einen kontinuierlichen Fluß der Reaktionsgase an der zu beschichtenden Fläche entlang ermöglicht, sowie Mittel zur Anregung einer Plasmazone in der zu reagierenden Gasschicht.

8. Vorrichtung nach Anspruch 7,
**dadurch gekennzeichnet,**
daß in die Wand des Gefäßteils (13) ein Rohr (17) eingelassen ist, das zum Zu- oder Abführen der Reaktionsgase an seinem aus dem Vakuumgefäß (3) herausragenden Ende mit einer Gasquelle oder einer Vakuumpumpe verbunden ist und an dessen anderem, zum Substratinnenraum hin weisenden Ende der Verdrängungskörper (6) so angebracht ist, daß er in axialer Richtung verschiebbar ist und der Kanal (16) im Verdrängungskörper (6) sich in dem Rohr (17) fortsetzt.

9. Vorrichtung nach Anspruch 8,
**dadurch gekennzeichnet,**
daß das Rohr (17) zum Zuführen der Reaktionsgase mit einer Gasquelle verbunden ist.

10. Vorrichtung nach Anspruch 8,
**dadurch gekennzeichnet,**
daß das Rohr (17) zum Zuführen der Reaktionsgase mit einer Gasquelle verbunden ist und der Verdrängungskörper (6) auf der der zu beschichtenden Fläche (7) zugewandten Seite als Gasdusche ausgebildet ist.

11. Vorrichtung zur Durchführung des Verfahrens, nach wenigstens einem der Ansprüche 1 bis 4, zur Innenbeschichtung eines einzelnen Substrats (1) mit offenem Kalottenhals (12),
**gekennzeichnet durch**
ein Vakuumgefäß (3), welches durch das gewölbte, im wesentlichen kalottenförmige Substrat (1) und ein mit diesem an den Rändern zusammengesetztes und gasdicht verbundenes, halbseitig offenes Gefäßteil (13) gebildet wird,
einen Verdrängungskörper (6), welcher zur Begrenzung der zu reagierenden Gasschicht in dem Vakuumgefäß (3) beabstandet und verschiebbar zu der zu beschichtenden Fläche (7) angeordet ist und dessen Gestalt auf der der zu beschichtenden Fläche (7) zugewandten Seite (11) im wesentlichen der Gestalt der Substratfläche (7) entspricht,
Mittel zur Halterung des Verdrängungskörpers (6) in dem Gefäßteil (13), eine Gasein- bzw. -auslaßöffnung (15) in dem Gefäßteil (13) zum Zu- bzw. Abführen der durch den offenen Kalottenhals zu- bzw. abführbaren Reaktionsgase sowie
Mittel zur Anregung einer Plamazone in der zu reagierenden Gasschicht.

12. Vorrichtung nach wenigstens einem der Ansprüche 6 bis 11,
**dadurch gekennzeichnet,**
daß der Verdrängungskörper (6) aus einem Material, das bis zu einer Temperatur von 200 °C formstabil und vakuumtauglich ist, besteht.

13. Vorrichtung nach Anspruch 12,
**dadurch gekennzeichnet,**
daß der Verdrängungskörper (6) aus einem Metallwerkstoff, insbesondere Al, Ti, Edelstahl oder einem dielektrischen Werkstoff, insbesondere Glas, Keramik, Glaskeramik, oder aus einem Kunststoff, insbesondere einem Fluorkohlenstoffharz, besteht.

## Claims

1. PCVD process for the production of a substantially dome-shaped substrate (1) which is provided on the inner and/or outer surface (7) with a dielectric and/or metal layer system, this substrate (1) in particular being a reflector having a dielectric cold-light mirror coating on the inside, characterized in that with the aid of a displacement body (6) whereof the shape on the side (11) facing the substrate surface (1) to be coated corresponds substantially to the shape of the substrate surface, the thickness of the gas layer to be reacted above the surface (7) to be coated of the substrate is adjusted such that the extent of the homogeneous reaction occurring in the gas layer during the plasma phase ("glass deposit formation") remains harmless for the desired layer quality.

2. Process according to Claim 1, characterized in that the thickness of the gas layer to be reacted is adjusted to 2 to 20 mm.

3. Process according to Claim 1 or 2, characterized in that the thickness of the gas layer to be reacted is adjusted by means of a displacement body (6) made from a material which is dimensionally stable up to a temperature of 200°C and is vacuum-compatible.

4. Process according to Claim 3, characterized in that the thickness of the gas layer to be reacted is adjusted by means of a displacement body (6) made from a metal material, in particular Al, Ti, special steel, or a dielectric material, in particular glass, ceramic, glass ceramic, or a synthetic material, in particular a fluorocarbon resin.

5. PCVD process for the production of a substantially dome-shaped substrate (6) provided on the inner surface (7) with a dielectric layer system and has an open dome neck (12) and a diameter at the dome base of less than 2 cm, this substrate (1) in particular being a reflector having a cold-light mirror coating on the inside, characterized in that coating is carried out in a container which comprises two substrates (1) joined together to form a vacuum vessel (25) and connected to one another in gas-tight manner, the reaction gases being guided through the openings in the dome necks in a continuous gas flow along against the surfaces to be coated and the plasma being generated in the whole reaction space delimited by the two substrates (1).

6. Apparatus for carrying out the process according to at least one of Claims 1 to 4, characterized by a vacuum vessel (3), means for mounting one or more substantially dome-shaped substrates (1) in the vacuum vessel (3), one or more displacement bodies (6), which is (are) spaced in the vacuum vessel (3) for delimiting the thickness of the gas layer to be reacted and is (are) arranged displaceably with respect to the surface(s) (7) to be coated and whereof the shape corresponds on the side (11) facing the surface (7) to be coated substantially to the shape of the substrate surface (7), gas inlet and outlet openings in the vacuum vessel (3) which are connected to a gas source and to a vacuum pump and are arranged such that the reaction gases can be guided in a continuous gas flow along against the surface(s) to be coated, and means for exciting a plasma zone in the gas layer to be reacted.

7. Apparatus for carrying out the process according to at least one of Claims 1 to 4, for the inner and/or outer coating of an individual substrate (1), characterized by a vacuum vessel (3), which is formed by the convex, substantially dome-shaped substrate (1) and a vessel part (13) which is joined and connected in gas-tight manner thereto at the edges and is open down one side, a displacement body (6) which is spaced in the vacuum vessel (3) for delimiting the gas layer to be reacted and is arranged displaceably with respect to the surface (7) to be coated and whereof the shape corresponds on the side (11) facing the surface (7) to be coated substantially to the shape of the substrate surface (7), means for mounting the displacement body (6) in the vessel part (13), a channel (16) in the displacement body (6) which opens on the side (11) of the displacement body (6) facing the surface to be coated into at least one gas inlet and outlet opening, means which connect the channel (16) to a gas source and to a vacuum pump outside the vacuum vessel (3), at least one further gas inlet and outlet opening in the vessel part (13) which is connected to a gas source and to a vacuum pump and which, together with the gas inlet and outlet opening in the displacement body (6), enable a continuous flow of the reaction gases along against the surface to be coated, and means for exciting a plasma zone in the gas layer to be reacted.

8. Apparatus according to Claim 7, characterized in that there is let into the wall of the vessel part (13) a tube (17) which, for supplying or removing the reaction gases, is connected at its end projecting out of the vacuum vessel (3) to a gas source or a vacuum pump and at the other end, pointing towards the substrate interior, of which the displacement body (6) is attached such that it is displaceable in the axial direction and the channel (16) in the displacement body (6) is prolonged in the tube (17).

9. Apparatus according to Claim 8, characterized in that the tube (17) for supplying the reaction gases is connected to a gas source.

10. Apparatus according to Claim 8, characterized in that the tube (17) for supplying the reaction gases is connected to a gas source and the displacement body (6) is constructed on the side facing the surface (7) to be coated as a gas spray.

11. Apparatus for carrying out the process according to at least one of Claims 1 to 4, for inner coating of an individual substrate (1) having an open dome neck (12), characterized by a vacuum vessel (3), which is formed by the convex, substantially dome-shaped substrate (1) and a vessel part (13) which is joined and connected in gas-tight manner thereto at the edges and is open down one side, a displacement body (6) which is spaced in the vacuum vessel (3) for delimiting the gas layer to be reacted and is arranged displaceably with respect to the surface (7) to be coated and whereof the shape corresponds on the side (11) facing the surface (7) to be coated substantially to the shape of the substrate surface (7), means for mounting the displacement body (6) in the vessel part (13), a gas inlet and outlet opening (15) in the vessel part (13) for supplying and removing the reaction gases which can be supplied and removed through the open dome neck, and means for exciting a plasma zone in the gas layer to be reacted.

12. Apparatus according to at least one of Claims 6 to 11, characterized in that the displacement body (6) is made of a material which is dimensionally stable up to a temperature of 200°C and is vacuum-compatible.

13. Apparatus according to Claim 12, characterized in that the displacement body (6) is made from a metal material, in particular Al, Ti, special steel, or a dielectric material, in particular glass, ceramic, glass ceramic, or a synthetic material, in particular a fluorocarbon resin.

## Revendications

1. Procédé C.V.D. assisté par plasma pour la fabrication d'un substrat (1) sensiblement en forme de calotte dont la surface intérieure et/ou la surface extérieure (7) est pourvue d'un système de couches diélectrique et/ou métallique, en particulier d'un réflecteur doté d'un revêtement intérieur diélectrique réfléchissant la lumière froide,
caractérisé par le fait
qu'au moyen d'un élément plongeur (6) dont la forme du côté (11) tourné vers la surface (1) à revêtir du substrat correspond sensiblement à celle de la surface du substrat, on règle l'épaisseur de la couche de gaz de réaction au-dessus de la surface à revêtir (7) du substrat de telle sorte que la réaction homogène (formation de dépôt sur le verte) qui a lieu dans la couche de gaz lors de la phase plasma reste sans incidence sur la qualité recherchée de la couche.

2. Procédé selon la revendication 1, caractérisé par le fait que l'on règle l'épaisseur de la couche de gaz de réaction entre 2 et 20 mm.

3. Procédé selon la revendication 1 ou 2, caractérisé par le fait que l'on règle l'épaisseur de la couche de gaz de réaction au moyen d'un élément plongeur (6) réalisé en un matériau dont la forme est stable jusqu'à 200 °C et qui supporte le vide.

4. Procédé selon la revendication 3, caractérisé par le fait que l'on règle l'épaisseur de la couche de gaz de réaction au moyen d'un élément plongeur (6) réalisé en un matériau métallique, notamment Al, Ti, acier spécial, ou en un matériau diélectrique, notamment verte, céramique, vitro-céramique, ou encore en une matière plastique, notamment en une résine fluoro-carbonée.

5. Procédé C.V.D. assisté par plasma pour la fabrication d'un substrat (6) sensiblement en forme de calotte avec un col (12) de calotte ouvert et un diamètre mesuré à la base de la calotte inférieur à 2 cm, dont la surface intérieure (7) est pourvue d'un système de couches diélectrique, notamment d'un réflecteur doté d'un revêtement intérieur diélectrique réfléchissant la lumière froide,
caractérisé par le fait
que l'on réalise le dépôt dans un récipient qui est constitué par deux substrats (1) assemblés et reliés entre eux de manière étanche au gaz pour former un récipient à vide (25), les gaz de réaction étant amenés en flux continu le long des surfaces à revêtir à travers les ouvertures dans les cols de calottes et le plasma étant produit dans l'ensemble de la chambre de réaction délimitée par les deux substrats (1).

6. Dispositif pour la mise en oeuvre du procédé selon au moins une des revendications 1 à 4, caractérisé par
un récipient à vide (3),
des moyens de support d'un ou plusieurs substrats (1) sensiblement en forme de calotte dans le récipient à vide (3), un ou plusieurs éléments plongeurs (6) qui, aux fins de limiter l'épaisseur de la couche de gaz de réaction, sont disposés dans le récipient à vide (3) à distance de la surface (7) à revêtir et avec possibilité de déplacement par rapport à celle-ci et dont la forme du côté (11) tourné vers la surface (7) à revêtir correspond sensiblement à la forme de la surface (7) du substrat,
des ouvertures d'entrée et de sortie de gaz dans le récipient (3) qui sont connectées à une source de gaz ou à une pompe à vide et qui sont disposées de manière telle que les gaz de réaction soient amenés en un flux continu le long de la/des surface(s) à revêtir,
ainsi que des moyens d'excitation d'une zone de plasma dans la couche de gaz de réaction.

7. Dispositif pour la mise en oeuvre du procédé selon au moins une des revendications 1 à 4 pour revêtir intérieurement et/ou extérieurement un substrat (1) unique, caractérisé par
un récipient à vide (3) qui est constitué par le substrat (1) bombé sensiblement en forme de calotte et une partie de récipient (13) ouverte d'un côté qui est assemblée avec ledit substrat au niveau des bords et est liée à celui-ci de manière étanche au gaz,
un élément plongeur (6) qui, aux fins de limiter l'épaisseur de la couche de gaz de réaction, est disposé dans le récipient à vide (3) à distance de la surface (7) à revêtir et avec possibilité de déplacement par rapport à celle-ci et dont la forme du côté (11) tourné vers la surface (7) à revêtir correspond sensiblement à la forme de la surface (7) du substrat,
des moyens de support de l'élément plongeur (6) dans la partie de récipient (13), un canal (16) dans l'élément plongeur (6) qui, du côté (11) de l'élément plongeur (6) tourné vers la surface à revêtir, débouche dans au moins une ouverture d'entrée ou de sortie de gaz,
des moyens qui relient le canal (16) à une source de gaz ou à une pompe à vide à l'extérieur du récipient à vide (3)
au moins une ouverture d'entrée ou de sortie de gaz supplémentaire dans la partie de récipient (13), laquelle ouverture est reliée à une source de gaz ou une pompe à vide et, avec l'ouverture d'entrée ou de sortie de gaz dans l'élément plongeur (6) permet d'obtenir un écoulement continu des gaz de réaction le long de la surface à revêtir,
ainsi que des moyens pour exciter une zone de plasma dans la couche de gaz de réaction.

8. Dispositif selon la revendication 7, caractérisé par le fait qu'un tube (17) est monté dans la paroi de la partie de récipient (13), lequel tube aux fins d'amener et d'évacuer les gaz de réaction par son extrémité sortant du récipient à vide (3) est connecté à une source de gaz ou une pompe à vide et à son autre extrémité tournée vers l'espace intérieur du substrat porte l'élément plongeur (6) de telle sorte que celui-ci puisse être déplacé dans la direction axiale et que le canal (16) dans ledit élément plongeur (6) se prolonge dans le tube (17).

9. Dispositif selon la revendication 8, caractérisé par le fait que le tube (17) pour l'amenée des gaz de réaction est connecté à une source de gaz.

10. Dispositif selon la revendication 8, caractérisé par le fait que le tube (17) pour l'amenée des gaz de réaction est connecté à une source de gaz et que l'élément plongeur (6), du côté tourné vers la surface (7) à revêtir, est agencé sous forme de douche à gaz.

11. Dispositif pour la mise en oeuvre du procédé selon au moins une des revendications 1 à 4 pour revêtir intérieurement un substrat (1) unique à col de calotte (12) est ouvert, caractérisé par
un récipient à vide (3) qui est constitué par le substrat (1) bombé sensiblement en forme de calotte et une partie de récipient (13) ouverte d'un côté qui est assemblée avec ledit substrat au niveau des bords et est liée à celui-ci de manière étanche au gaz,
un élément plongeur (6) qui, aux fins de limiter l'épaisseur de la couche de gaz de réaction, est disposé dans le récipient à vide (3) à distance de la surface (7) à revêtir et avec possibilité de déplacement par rapport à celle-ci et dont la forme du côté (11) tourné vers la surface (7) à revêtir correspond sensiblement à la forme de la surface (7) du substrat,
des moyens de support de l'élément plongeur (6) dans la partie du récipient (13), une entrée ou une sortie de gaz (15) dans la partie de récipient (13) pour amener ou évacuer les gaz de réaction introduit ou évacués par le col de calotte ouvert,
ainsi que des moyens pour exciter une zone de plasma dans la couche de gaz de réaction.

12. Dispositif selon au moins une des revendications 6 à 11, caractérisé par le fait que l'élément plongeur (6) est réalisé en un matériau dont la forme est stable jusqu'à une température de 200 °C et qui supporte le vide.

13. Dispositif selon la revendication 12, caractérisé par le fait que l'élément plongeur (6) est réalisé en un matériau métallique en particulier Al, Ti, acier spécial ou en un matériau diélectrique, en particulier, verre, céramique, vitro-céramique ou en une matière plastique, en particulier une résine fluoro-carbonée.
